Europäisches Patentamt

European Patent Office

Office européen des brevets

(19)

(11) **EP 0 624 954 B1**

(12) **FASCICULE DE BREVET EUROPEEN**

(45) Date de publication et mention
de la délivrance du brevet:
**08.10.1997 Bulletin 1997/41**

(51) Int Cl.⁶: **H03L 7/02**, H03L 7/16

(21) Numéro de dépôt: **94401021.4**

(22) Date de dépôt: **09.05.1994**

(54) **Dispositif de réduction des raies parasites du signal de sortie d'un synthétiseur de fréquence numérique**

Vorrichtung zur Verminderung der Störspektrallinien des Ausgangssignals eines digitalen Frequenzsynthetisierers

Arrangement for reducing the spurious spectral lines contained in a digital frequency synthesizer output signal

(84) Etats contractants désignés:
**DE DK ES FR GB IT NL SE**

(30) Priorité: **12.05.1993 FR 9305704**

(43) Date de publication de la demande:
**17.11.1994 Bulletin 1994/46**

(73) Titulaire: **ALCATEL ALSTHOM COMPAGNIE GENERALE D'ELECTRICITE**
**75008 Paris (FR)**
Etats contractants désignés:
**DE DK ES FR GB IT NL SE**

(72) Inventeurs:
- **Beuzer, Michel**
  **F-91260 Juvisy sur Orge (FR)**
- **Bourcereau, Antoine**
  **F-92600 Asnières sur Seine (FR)**

(74) Mandataire: **Renaud-Goud, Thierry et al**
**c/o ALCATEL ALSTHOM,**
**Département de Propriété Industrielle,**
**30, avenue Kléber**
**75116 Paris (FR)**

(56) Documents cités:
EP-A- 0 044 153          EP-A- 0 492 588
GB-A- 2 239 748

- **IEE COLLOQUIUM ON 'DIRECT DIGITAL FREQUENCY SYNTHESIS', 19 Novembre 1991, LONDON, UK pages 1 - 5 WILSON M. P. ET AL. 'SPURIOUS REDUCTION TECHNIQUES FOR DIRECT DIGITAL SYNTHESIS'**
- **ELECTRONICS WORLD AND WIRELESS WORLD, vol.98, no.1679, Novembre 1992, SURREY GB pages 937 - 941, XP316264 IAN HICKMAN 'PUTTING DDS TO WORK'**
- **ELECTRONICS WORLD AND WIRELESS WORLD, vol.98, no.1678, Octobre 1992, SURREY GB pages 842 - 845, XP315541 IAN HICKMAN 'GENUINE SOLUTIONS TO SPURIOUS ARGUMENTS'**

**Description**

Le domaine de l'invention est celui des synthétiseurs de fréquence et concerne plus particulièrement un dispositif permettant de réduire l'amplitude des raies parasites du signal de sortie d'un synthétiseur de fréquence numérique, encore appelé DDS (Digital Direct Synthesizer).

Les synthétiseurs de fréquence numériques permettent d'obtenir une résolution en fréquence très fine et présentent une faible densité de bruit de phase. En revanche, ils génèrent des raies parasites dues notamment à l'échantillonnage, la troncature de phase et à la quantification. Ces raies parasites peuvent être très proches de la fréquence que l'on veut générer et donc difficiles, voire impossibles, à éliminer par des méthodes classiques de filtrage.

On connaît des dispositifs (voir GB-A-2 239 748) aptes à diminuer l'amplitude des raies parasites des signaux générés par des synthétiseurs de fréquence numériques. Ces dispositifs emploient par exemple un filtre bande étroite agile en fréquence en sortie du synthétiseur. Cependant, ces filtres doivent être pilotés de façon très précise pour que leur fréquence centrale soit centrée sur la fréquence du signal de sortie du synthétiseur que l'on veut obtenir. De plus, leur bande passante très faible les rend onéreux et difficilement réalisables.

La présente invention a notamment pour objectif de pallier ces inconvénients.

Plus précisément, un des objectifs de l'invention est de fournir un dispositif apte à réduire de façon importante l'amplitude des raies parasites du signal de sortie d'un synthétiseur de fréquence numérique, sans employer de filtre à bande étroite.

Cet objectif, ainsi que d'autres qui apparaîtront par la suite, est atteint grâce à un dispositif de réduction des raies parasites du signal de sortie d'un synthétiseur de fréquence numérique recevant un premier signal d'horloge ainsi qu'un mot de commande et fournissant le signal de sortie à une fréquence pure modulée par des fréquences parasites, le premier signal d'horloge étant issu d'un modulateur et le dispositif comprenant un démodulateur de fréquence recevant le signal de sortie du synthétiseur et fournissant un signal de correction dont l'amplitude est fonction de l'excursion de fréquence du signal de sortie du synthétiseur, le signal de correction étant appliqué au modulateur pour qu'il module le signal appliqué au synthétiseur en opposition de phase par rapport à la modulation parasite, de manière à supprimer cette modulation parasite.

Avantageusement, le démodulateur est un démodulateur à ligne à retard. Il n'est dès lors pas nécessaire de prévoir un générateur de fréquence pure pour obtenir l'excursion de fréquence du signal de sortie du synthétiseur.

Dans un mode de réalisation préférentiel, un écrêteur est disposé entre le synthétiseur et le démodulateur afin de supprimer une éventuelle modulation d'amplitude introduite par ce synthétiseur.

Le modulateur peut être compris dans un oscillateur commandé en tension recevant comme signal de commande le signal de correction issu du démodulateur.

Dans un autre mode de réalisation, le modulateur est un mélangeur recevant d'une part le signal de correction issu du démodulateur et d'autre part un second signal d'horloge.

D'autres caractéristiques et avantages de l'invention apparaîtront à la lecture de la description suivante d'un mode de réalisation préférentiel, donné à titre illustratif et non limitatif, et des dessins annexés dans lesquels :

- la figure 1 est un schéma synoptique d'un mode de réalisation de l'invention ;
- la figure 2 est un schéma synoptique d'un mode de réalisation du démodulateur de la figure 1 ;
- la figure 3 est un schéma synoptique d'une expérimentation du dispositif de l'invention ;
- la figure 4 représente le spectre du signal de sortie du modulateur de la figure 1 en boucle ouverte ;
- la figure 5 représente l'excursion de fréquence pour le signal de la figure 4.

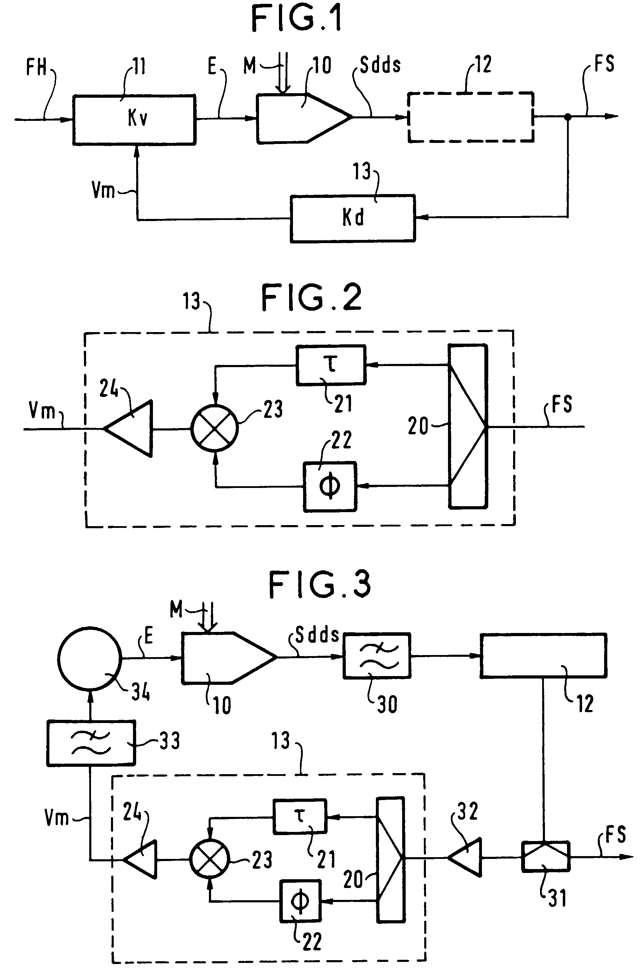

Sur la figure 1 est représenté un dispositif de réduction des raies parasites d'un synthétiseur de fréquence numérique 10. De façon connue, le synthétiseur 10 est constitué par un accumulateur de phase recevant un mot de commande M et un premier signal d'horloge E, cet accumulateur étant suivi d'une mémoire morte elle-même suivie d'un convertisseur numérique-analogique fournissant le signal de sortie du synthétiseur.

Selon l'invention, le premier signal d'horloge E est issu d'un modulateur 11. Le signal de sortie Sdds du synthétiseur 10 est appliqué à un écrêteur 12 optionnel fournissant un signal de sortie de fréquence FS. Une fraction de ce signal est appliquée à un démodulateur 13 dont le signal de sortie, appelé signal de correction et d'amplitude Vm, est appliqué au modulateur 11. Le modulateur 11 reçoit un second signal d'horloge de fréquence FH, généralement fixe et servant de référence. Le modulateur 11 et le démodulateur 13 ont respectivement pour pentes Kv (en Hz/V) et -Kd (en V/Hz). On notera que l'essentiel est que ces pentes soient de signes opposés.

Le fonctionnement de ce dispositif est le suivant :

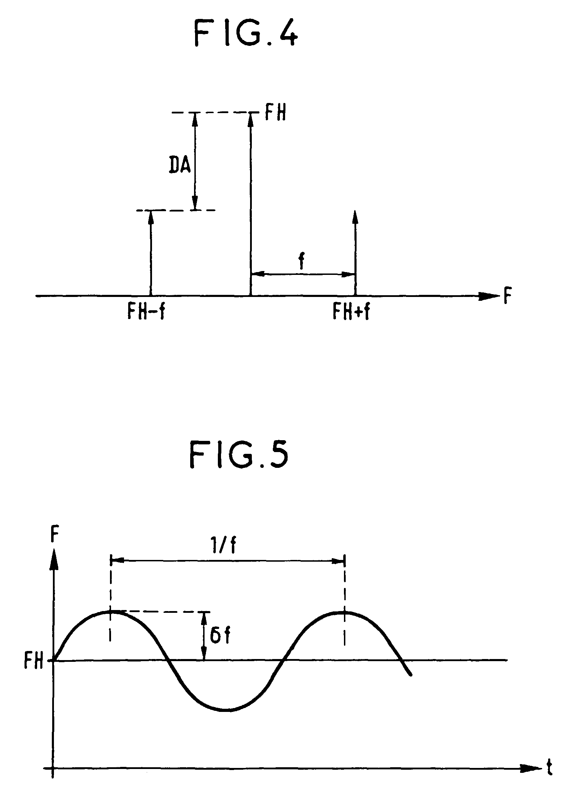

En boucle ouverte, le modulateur 11 reçoit le second signal d'horloge de fréquence FH, et lorsqu'on lui applique un signal sinusoidal de fréquence f et d'amplitude Vm, ce modulateur 11 fournit un signal dont le spectre est représenté à la figure 4. La raie principale est à la fréquence FH et deux raies parasites sont distantes de f de cette raie principale (FH-f et FH+f). La différence d'amplitude des raies, notée DA, est égale à :

$$DA = 20 \log \frac{\delta f}{2f} \qquad \text{avec } \delta f = Vm.Kv$$

$\delta f$ est appelé l'excursion de fréquence et représenté sur la figure 5. La figure 5 représente le signal d'amplitude Vm et de fréquence f par rapport à la fréquence FH en fonction du temps. Le signal d'horloge E de sortie du modulateur 11 est appliqué à l'entrée du synthétiseur 10. Le signal de sortie Sdds du synthétiseur 10 est constitué d'une raie à la fréquence désirée Fdds (fonction de M) et de raies parasites. On a :

$$Fdds = \frac{(FH+Vm.Kv) \cdot M}{2^n}$$

où n est le nombre de bits de l'accumulateur de phase du synthétiseur 10.

L'écrêteur 12, qui a pour fonction de supprimer l'éventuelle modulation d'amplitude affectant le signal Sdds, fournit donc le signal de fréquence FS modulé en fréquence par les raies parasites. Cet écrêteur est optionnel et est utilisé lorsque le synthétiseur 10 génère une modulation d'amplitude.

Une fraction de ce signal est appliquée au démodulateur 13, par exemple celui représenté à la figure 2, et celui-ci délivre un signal dont l'amplitude est proportionnelle à l'excursion en fréquence du signal de fréquence FS.

L'amplitude de ce signal, notée Vm' est égale à:

$$Vm' = \frac{-Kd.Kv.Vm.M}{2^n}$$

En boucle fermée, la tension Vm' est égale à Vm et module le signal de fréquence FH en opposition de phase par rapport à la modulation parasite.

L'excursion de fréquence en boucle fermée, notée $\delta F'$, est alors égale à:

$$\delta F' = \frac{\delta f}{1 - \dfrac{Kv.Kd.M}{2^n}}$$

où $\delta f$ est l'excursion de fréquence parasite en boucle ouverte.

On constate donc que si l'on choisit le rapport $(Kv.Kd.M)/2^n$ grand, l'excursion de fréquence $\delta F'$, et donc la modulation parasite, tend à être annulée. Ainsi, la modulation en opposition de phase du signal de fréquence FH par un signal représentatif de l'excursion de fréquence du signal de sortie FS permet de supprimer (ou tout du moins de diminuer fortement) l'amplitude des raies parasites. En général, plusieurs fréquences parasites modulent le signal désiré en sortie du dispositif de l'invention et le signal de correction d'amplitude Vm issu du démodulateur 13 a alors une allure représentative de la somme des écarts de fréquence entre la fréquence centrale FS à obtenir et ces fréquences parasites.

Le modulateur 11 peut être réalisé de différentes manières. On peut par exemple employer un simple mélangeur ou alors un modulateur de phase. Dans ce dernier cas, le signal de correction sera appliquée au modulateur 11 par l'intermédiaire d'un intégrateur.

Le second signal d'horloge de fréquence FH peut être généré par un oscillateur commandé en tension (VCO), éventuellement stabilisé en température (VCXO). Le signal de correction est alors appliqué à l'entrée de commande du VCO. Dans un autre mode de réalisation, le second signal d'horloge est issu d'un oscillateur à quartz.

La figure 2 représente un mode de réalisation du démodulateur 13 de la figure 1.

Le démodulateur 13 comporte un diviseur de puissance 20 assurant une division du signal de fréquence FS en deux voies. L'une de ces voies comporte une ligne à retard 21 apportant un retard de durée $\tau$ et l'autre voie un déphaseur variable 22 de phase $\Phi$. Le déphaseur 22 est optionnel. Les sorties de la ligne à retard 21 et du déphaseur 22 sont appliquées à un discriminateur de phase 23 de pente $K\Phi$ suivi d'un amplificateur 24 de gain G négatif fournissant le signal de correction d'amplitude Vm. Un tel démodulateur est connu et est généralement appelé "démodulateur de fréquence à ligne à retard". Il permet d'obtenir un signal de sortie d'amplitude Vm représentatif de l'excursion en fréquence du signal appliqué à son entrée, sans utiliser de signal de fréquence de référence.

Le déphaseur 22 est réglé pour que les signaux appliqués au discriminateur de phase 23 soient en quadrature de phase lorsque le signal de sortie du synthétiseur 10 a une fréquence placée au centre de la bande de fréquence utile.

La bande de fréquence utile BFU en entrée du démodulateur 13 est donnée par $BFU = 1/4\tau$ alors que la pente Kd du démodulateur 13 est égale à $G.K\Phi.\tau$ pour $\omega_m.\tau/2$ petit (mais non nul) et différent de $k\pi$ ($\omega_m$ est la pulsation de modulation). On démontre que $Vm = -Kd. 2\pi\delta F$.

Les performances du dispositif de réduction de raies parasites de l'invention dépendent de la valeur de $\tau$. On réalisera donc un compromis satisfaisant entre une bande de fréquence utile BFU importante ($\tau$ petit) et une pente Kd du démodulateur suffisante pour obtenir l'annulation des raies parasites tout en respectant la condition précédente sur Kd ($\tau$ grand). On choisit une valeur de $\tau$ petite car le rapport $\omega_m.\tau/2$ est un coefficient de sensibilité qui affecte le taux de modulation.

Selon un autre mode de réalisation, le démodulateur peut être constitué par un simple mélangeur recevant un signal de fréquence pure FS et le signal de sortie de l'écrêteur 12. Un tel démodulateur fournirait alors un signal de battement représentatif de l'écart entre la fréquence FS désirée et la fréquence FS effective perturbée par les raies parasites. Il est cependant alors nécessaire de disposer d'un générateur de fréquence pure, par exemple constitué par un oscillateur commandé en tension ne générant pas d'harmoniques.

Dans un autre mode de réalisation, le démodulateur 13 est constitué par un filtre atténuateur. En travaillant dans la bande d'atténuation, on extrait l'excursion de fréquence que l'on détecte avant de l'amplifier.

La figure 3 est un schéma synoptique d'une expérimentation du dispositif de l'invention.

Un filtre passe-bas 30 est inséré entre la sortie du synthétiseur de fréquence 10 et l'écrêteur 12. Il a une fréquence de coupure de 50 MHz. L'écrêteur 12 est un circuit MC10101 qui supprime la modulation d'amplitude et est suivi d'un coupleur 31 fournissant le signal de sortie de fréquence pure FS égale à 44 MHz. La branche d'asservissement comporte un amplificateur 32 suivi du démodulateur 13 de la figure 2. La durée du retard $\tau$ est de 20 ns et le gain G de l'amplificateur 24 est égal à -500. Le signal Vm est appliqué à un filtre de boucle 33 suivi d'un VCO fonctionnant à 240 MHz. La valeur de Kv est ici de 2 MHz/V. Un tel dispositif permet d'obtenir une réduction de 10 à 20 dB du niveau des raies parasites pour des fréquences de modulation parasites inférieures à 200 kHz, par rapport au niveau des raies parasites sans le dispositif de la présente invention.

Le dispositif de l'invention permet d'obtenir une atténuation des raies parasites proches de la fréquence FS de sortie souhaitée quelque soit leur origine et ce pour un coût raisonnable. Il n'utilise pas de filtre bande étroite agile en fréquence.

Par ailleurs, la limitation de bande de fréquence de sortie n'est pas contraignante dans la mesure où les synthétiseurs de fréquence numériques ne sont pas employés sur toute leur plage théorique de fonctionnement (de 0 à FH/2) dans les systèmes où l'on recherche une importante pureté spectrale du signal de sortie.

On peut également noter qu'il est possible d'augmenter la bande de fréquence du dispositif en modifiant la valeur du retard $\tau$ en fonction de la fréquence du signal de sortie.

Enfin, la pente Kd du démodulateur peut être positive et, dans ce cas, la pente Kv du modulateur (ou du VCO) est négative.

## Revendications

1. Dispositif de réduction des raies parasites du signal de sortie (Sdds) d'un synthétiseur de fréquence numérique (10) recevant un premier signal d'horloge (E) ainsi qu'un mot de commande (M) et fournissant ledit signal de sortie (Sdds) à une fréquence pure (FS) modulée par des fréquences parasites, caractérisé en ce que ledit premier signal d'horloge (E) est issu d'un modulateur (11) et en ce qu'il comporte un démodulateur de fréquence (13) recevant ledit signal de sortie (Sdds) dudit synthétiseur (10) et fournissant un signal de correction dont l'amplitude (Vm) est fonction de l'excursion de fréquence dudit signal de sortie (Sdds) dudit synthétiseur (10), ledit signal de correction étant appliqué audit modulateur (11) pour qu'il module ledit signal appliqué audit synthétiseur (10) en opposition de phase par rapport à ladite modulation parasite, de manière à supprimer ladite modulation parasite.

2. Dispositif selon la revendication 1, caractérisé en ce que ledit démodulateur (13) est un démodulateur à ligne à retard (21).

3. Dispositif selon l'une des revendications 1 et 2, caractérisé en ce qu'un écrêteur (12) est disposé entre ledit synthétiseur (10) et ledit démodulateur (13) afin de supprimer une éventuelle modulation d'amplitude introduite par ledit synthétiseur (10).

4. Dispositif selon l'une des revendications 1 à 3, caractérisé en ce que ledit modulateur est compris dans un oscillateur commandé en tension (34) recevant comme signal de commande ledit signal de correction dudit démodulateur.

5. Dispositif selon l'une des revendications 1 à 3, caractérisé en ce que ledit modulateur est un mélangeur (11) recevant d'une part ledit signal de correction issu dudit démodulateur (13) et d'autre part un second signal d'horloge (FH).

## Patentansprüche

1. Vorrichtung zur Verringerung der störenden Spektrallinien des Ausgangssignals (SDDS) eines digitalen Frequenzsynthetisierers (10), der ein erstes Taktsignal (E) sowie ein Steuerwort (M) empfängt und das Ausgangssignal (Sdds) mit einer reinen Frequenz (FS) liefert, die durch Störfrequenzen moduliert ist,
dadurch gekennzeichnet, daß das erste Taktsignal (E) aus einem Modulator (11) stammt und daß die Vorrichtung einen Frequenzdemodulator (13) besitzt, der das Ausgangssignal (SDDS) des Synthetisierers (10) empfängt und ein Korrektursignal liefert, dessen Amplitude (Vm) von der Frequenzexkursion des Ausgangssignals (Sdds) des Synthetisierers (10) abhängt und das an den Modulator (11) angelegt wird, um das an den Synthetisierer (10) angelegte Signal in Gegenphase bezüglich der störenden Modulation zu modulieren, so daß die störende Modulation unterdrückt wird.

2. Vorrichtung nach Anspruch 1, dadurch gekennzeichnet, daß der Demodulator (13) ein Demodulator mit Verzögerungsleitung (21) ist.

3. Vorrichtung nach einem der Ansprüche 1 und 2, dadurch gekennzeichnet, daß ein Begrenzer (12) zwischen dem Synthetisierer (10) und dem Demodulator (13) liegt, um eine eventuelle Amplitudenmodulation zu unterdrücken, die durch den Synthetisierer (10) eingeführt worden sein könnte.

4. Vorrichtung nach einem der Ansprüche 1 bis 3, dadurch gekennzeichnet, daß der Modulator in einem spannungsgesteuerten Oszillator (34) enthalten ist, der als Steuersignal das Korrektursignal des Demodulators empfängt.

5. Vorrichtung nach einem der Ansprüche 1 bis 3, dadurch gekennzeichnet, daß der Modulator eine Mischstufe (11) ist, die einerseits das Korrektursignal aus dem Demodulator (13) und andererseits ein zweites Taktsignal (FH) empfängt.

**Claims**

1. Device for reducing unwanted components of the output signal (Sdds) of a digital direct synthesiser (10) receiving a first clock signal (E) and a control word (M) and supplying said output signal (Sdds) at a pure frequency (FS) modulated by unwanted frequencies,
   characterised in that said first clock signal (E) is obtained from a modulator (11) and in that it includes a frequency demodulator (13) receiving said output signal (Sdds) of said synthesiser (10) and supplying a correction signal whose amplitude (Vm) is conditioned by the frequency excursion of said output signal (Sdds) of said synthesiser (10), said correction signal being applied to said modulator (11) so that it modulates said signal applied to said synthesiser (10) 180° out of phase with said unwanted modulation, so as to eliminate said unwanted modulation.

2. Device according to claim 1 characterised in that said demodulator (13) is a demodulator employing a delay line (21).

3. Device according to claim 1 or claim 2 characterised in that a peak limiter (12) between said synthesiser (10) and said demodulator (13) eliminates any amplitude modulation introduced by said synthesiser (10).

4. Device according to any one of claims 1 to 3 characterised in that said modulator is part of a voltage-controlled oscillator (34) receiving said correction signal from said demodulator as its control signal.

5. Device according to any one of claims 1 to 3 characterised in that said modulator is a mixer (11) receiving said correction signal from said demodulator (13) and a second clock signal (FH).

# FIG.1

# FIG.2

# FIG.3

EP 0 624 954 B1

# FIG.4

# FIG.5